(19) Europäisches Patentamt
European Patent Office
Office européen des brevets

(11) **EP 0 602 466 B1**

(12) **EUROPÄISCHE PATENTSCHRIFT**

(45) Veröffentlichungstag und Bekanntmachung des Hinweises auf die Patenterteilung:
**04.03.1998 Patentblatt 1998/10**

(51) Int Cl.⁶: **G05F 1/56**, G05F 3/30

(21) Anmeldenummer: **93119431.0**

(22) Anmeldetag: **02.12.1993**

(54) **Monolithisch integrierter Spannungsregler**

Monolithic integrated voltage regulator

Régulateur de tension integré monolithique

(84) Benannte Vertragsstaaten:
**DE FR GB IT NL**

(30) Priorität: **18.12.1992 DE 4242989**

(43) Veröffentlichungstag der Anmeldung:
**22.06.1994 Patentblatt 1994/25**

(73) Patentinhaber: **Micronas Intermetall GmbH 79108 Freiburg (DE)**

(72) Erfinder:
• **Theus, Ulrich, Dr.-Ing. D-79194 Gundelfingen (DE)**
• **Kessel, Jürgen, Dipl.-Ing. D-79102 Freiburg i.Br. (DE)**

(56) Entgegenhaltungen:
EP-A- 0 199 427    EP-A- 0 460 263
EP-A- 0 508 327    DE-A- 2 708 021
GB-A- 2 034 937    US-A- 5 182 525

**Beschreibung**

Die Erfindung betrifft einen eine Regelschleife enthaltenden Spannungsregler zur Erzeugung einer geregelten Versorgungsspannung. Der Spannungsregler arbeitet dabei als Längsregler, dessen Stellglied zwischen einer ersten und zweiten Anschlußklemme liegt, an der eine ungeregelte Versorgungsspannung angeschlossen bzw. die geregelte Versorgungsspannung abgreifbar ist. Eine dritte Anschlußklemme verbindet den Spannungsregler mit einem festen Bezugspotential, das in der Regel das Massepotential ist. Die Regelschleife enthält in Signalflußrichtung ein Referenznetzwerk, das die Signale für den Soll-istvergleich liefert, eine Differenzeinrichtung mit einem ersten Verstärkungsfaktor, die ein von der Regelabweichung abhängiges Signal erzeugt, und das Stellglied mit einem zweiten Verstärkungsfaktor. Damit die Ausgangssignale des Referenznetzwerkes und der Differenzeinrichtung möglichst unabhängig von Signalschwankungen und Störeinflüssen der ungeregelten Versorgungsspannung sind, werden sie von der geregelten Versorgungsspannung gespeist. Für das Anlaufverhalten derartiger Spannungsregler, also der Betrieb aus dem spannungslosen Zustand heraus, z.B. im Kraftfahrzeugbereich, wenn eine batteriegespeiste Bordversorgung eingeschaltet wird, ist eine Starteinrichtung erforderlich, die statisch oder dynamisch den Anlauf der Regelschleife sicherstellen kann.

Ein monolithisch integrierbarer Spannungsregler ist beispielsweise in EP-A 0 491 980 beschrieben. Es handelt sich dabei um einen Spannungsregler in CMOS-Technik, dessen geregelte Ausgangsspannung Signalverarbeitungsschaltungen speist, die auf der Halbleiteroberfläche monolithisch mitintegriert sind.

Ein Nachteil des aus EP-A 0 491 980 bekannten Spannungsreglers besteht darin, daß die einzelnen, nur begrenzt versorgungsspannungsunabhängigen Stufen der Regelschleife an die ungeregelte Versorgungsspannung angeschlossen sind. Störsignale auf der Versorgungsleitung, wie kurze Spannungsspitzen oder hochfrequente Störsignale, die beispielsweise auch im Bordnetz eines Kraftfahrzeuges auftreten können, wirken sich somit bis auf die geregelte Ausgangsspannung aus. Dieser Effekt wird noch zusätzlich verstärkt, wenn die Ausgangsspannung nicht durch externe, große Siebmittel gepuffert wird, sondern allenfalls durch relativ kleine, mitintegrierte Kondensatoren.

In DE 30 10 618 C2 ist ein Spannungsregler mit der eingangs aufgeführten Schaltungsanordnung sowie mit der Starteinrichtung beschrieben, um während der Startphase die Regelschleife in einen regulären Betriebsbereich zu ziehen. Da die gesamte Schaltung des Spannungsreglers nur sehr wenige aktive und passive Bauelemente aufweist, reicht als Starteinrichtung eine Hilfsschaltung aus, die den Ausgang des Spannungsreglers über eine einfache Spannungs-Stabilisierungsschaltung an die ungeregelte Versorgungsspannung anschließt. Die Starteinrichtung wird jedoch erst ab einer relativ großen Versorgungsspannung aktiv.

Wenn der Spannungsregler aufwendigere Funktionseinheiten in seiner Regelschaltung aufweist, dann führt eine Minimalversorgung des Reglerausganges nicht zum Ziel, zum Beispiel wenn einzelne Stufen der Regelschaltung im Anlaufbereich noch nicht richtig in Betrieb sind. Im Anlaufbereich ist beispielsweise die richtige Regelrichtung keinesfalls gesichert, weil einzelne Stufen der Regelschleife entweder noch völlig stromlos sind oder noch nicht richtig arbeiten. Wenn die Regelrichtung im Anlaufbereich invertiert ist, gelangt der Spannungsregler überhaupt nie in seinen ordentlichen Betriebsbereich. Es ist daher Aufabe der im Anspruch 1 gekennzeichneten Erfindung, eine verbesserte Starteinrichtung für einen Spannungsregler anzugeben, der direkt in die Regelschaltung eingreift, um diese in einen sicheren Betriebsbereich zu ziehen, wobei die gesamte Schaltung monolithisch integrierbar sein soll.

Diese Aufgabe wird erfindungsgemäß durch die im Anspruch 1 gekennzeichneten Merkmale gelöst. Vorteilhafte Weiterbildungen der Erfindung ergeben sich aus den Unteransprüchen.

Die Erfindung und weitere Vorteile werden nun anhand der Figuren der Zeichnung näher erläutert:

Fig. 1 zeigt schematisch als Blockschaltbild ein Ausführungsbeispiel des Spannungsreglers nach der Erfindung,

Fig. 2 zeigt ein bevorzugtes Ausführungsbeispiel einiger Stufen des Spannungsreglers,

Fig. 3 zeigt einen CMOS-Transkonduktanzverstärker als bevorzugtes Ausführungsbeispiel der Stelleinrichtung,

Fig. 4 zeigt schematisch im Diagramm einige Spannungskennlinien als Funktion der geregelten Ausgangsspannung, und

Fig. 5 und Fig. 6 zeigen schematisch im Diagramm einige Stromkennlinien als Funktion der geregelten Ausgangsspannung.

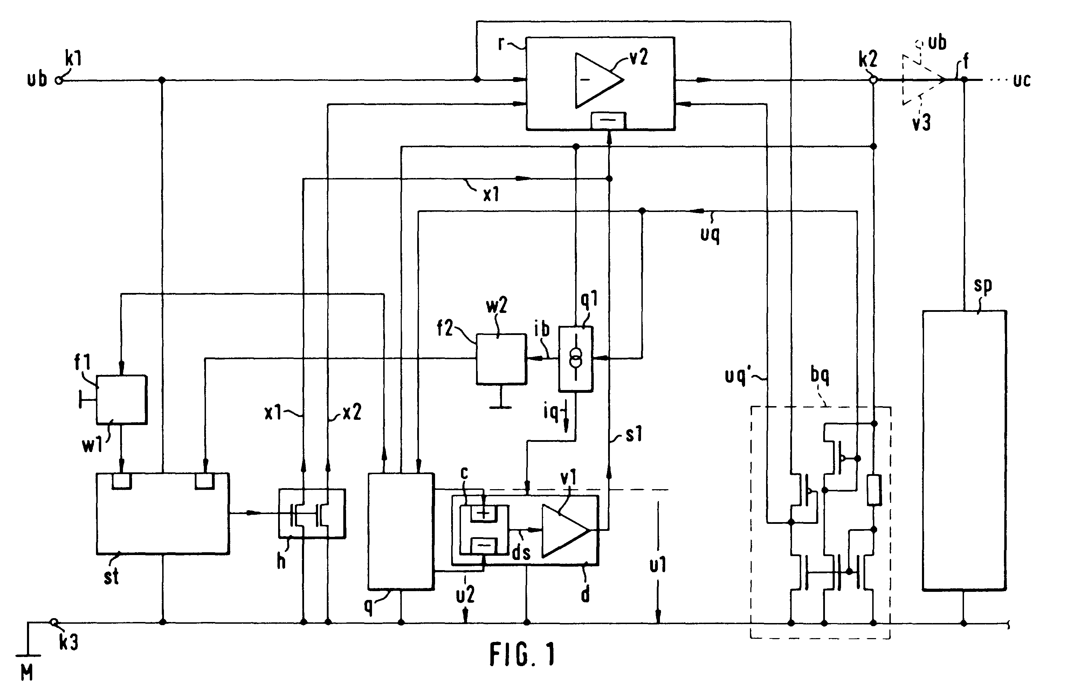

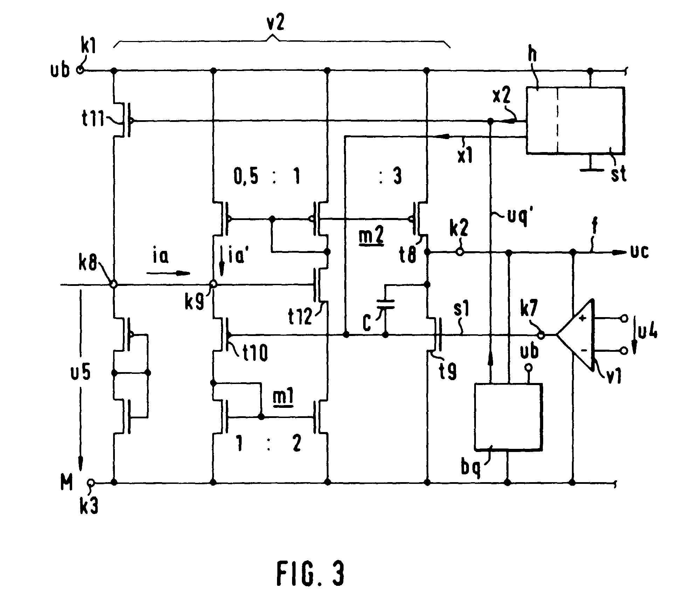

Die Regelstrecke des in Fig. 1 schematisch darstellen Spannungsreglers liegt zwischen einer ersten und zweiten Anschlußklemme k1, k2. An die erste Anschlußklemme ist eine ungeregelte Versorgungsspannung ub angeschlossen und an der zweiten Anschlußklemme k2 wird eine geregelte Versorgungsspannung uc abgegriffen. Als Stellglied r zwischen der ersten und zweiten Anschlußklemme dient ein zweiter Verstärker v2, dessen invertierendem Eingang ein Stellsignal s1 zugeführt ist (vgl. Fig. 3). Die Verwendung des zweiten Verstärkers v2 gegenüber einem einzelnen Transistor hat den Vorteil, daß die ungeregelte Versorgungsspannung weniger auf die zweite Anschlußklemme k2 durchgreifen kann. Wenn der zweite Verstärker v2 ferner über einen Gegentaktausgang verfügt, ist der Innenwiderstand des Spannungsreglers für beide Ausgangsstromrichtungen etwa gleich niedrig. Für größere Ausgangsleistungen wird dem Spannungsregler eine Leistungsstufe v3 nachgeschaltet, die beispielsweise durch einen Impedanzwandler realisiert sein kann.

Ein Bezugspotential M, das in der Regel dem Massepotential entspricht, ist an eine dritte Anschlußklemme k3 des Spannungsreglers angeschlossen. Zwischen dem Impedanzwandlerausgang bzw. der zweiten und dritten Anschlußklemme k2, k3 liegt ein Schaltungsblock sp, der eine Vielzahl von analogen und/oder digitalen Signalverarbeitungseinrichtungen darstellen soll, die von der geregelten Versorgungsspannung uc über eine interne Versorgungsleitung f gespeist werden. Besonders vorteilhaft ist es, wenn der Spannungsregler und die Signalverarbeitungseinrichtungen sp gemeinsam auf einer Halbleiteroberläche monolithisch integriert werden. Die Signalverarbeitungseinrichtungen sp lassen sich dann auf einfache Weise, beispielsweise über Schaltungsbibliotheken, in Standard-CMOS-Technik herstellen, wobei die Schaltungsauslegung und der Herstellungsprozeß für den Wert der geregelten Versorgungsspannung uc optimiert sind. Die ungeregelte, höhere Versorgungsspannung ub muß nur für die Auslegung des Spannungsreglers an einigen Stellen berücksichtigt werden.

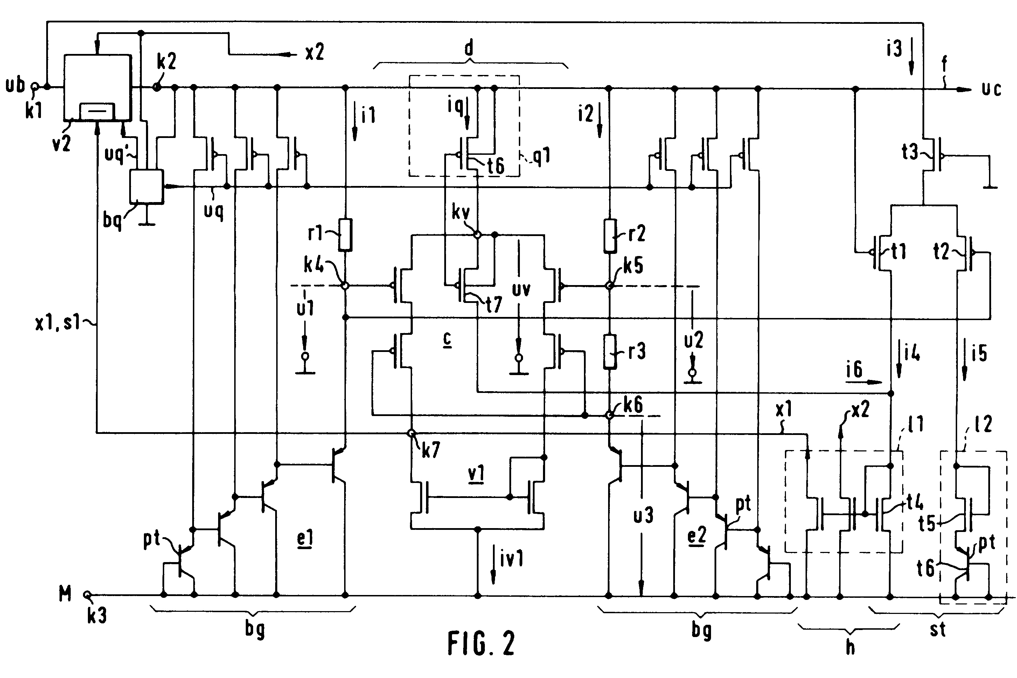

Die Regelschleife des Spannungsreglers in Fig. 1 enthält ein Referenznetzwerk q, eine Differenzeinrichtung d, die eine Differenzstufe c und einen ersten Verstärker v1 einschließt, und den zweiten Verstärker v2. Die Differenzstufe c bildet als Maß für die Regelabweichung ein Differenzsignal ds aus einer ersten und zweiten Spannung u1 bzw. u2, die das Referenznetzwerk q liefert. Die Spannung u1 kann beispielsweise mittels einer Diodenstrecke, einer Abbruchstrecke oder einer Bandgap-Schaltung (= Bandabstands-Referenzschaltung) gewonnen werden. Die zweite Spannung u2 wird im einfachsten Fall mittels eines ohmschen Spannungsteilers aus der geregelten Versorgungsspannung uc abgeleitet. Im Ausführungsbeispiel nach Fig. 2 werden mittels einer Bandgap-Schaltung eine von der geregelten Versorgungsspannung uc abhängige erste und zweite Spannung u1, u2 mit unterschiedlichem Kennlinienverlauf erzeugt. Der Schnittpunkt beider Kennlinien steht dabei in direkter Abhängigkeit zum Sollwert für die Regelschleife. Der erste Verstärker v1 in Fig. 1 ist an seinem Eingang mit dem Differenzsignal ds aus der Differenzstufe c gespeist und gibt an seinem Ausgang das Stellsignal s1 ab. Eine frequenzabhängige Gegenkopplung im zweiten Verstärker stabilisiert die Regelschleife. Die Realisierung der einzelnen Stufen ist nicht an die Ausführungsbeispiele gebunden, weder in der Schaltungstechnik noch im Herstellungsverfahren.

In Fig. 1 ist in vereinfachter Form eine Vorspannungsquelle bq dargestellt, deren Steuereingang an die geregelte Versorgungsspannung uc angeschlossen ist und eine erste und zweite Vorspannung uq, uq' erzeugt. Mit der Vorspannung uq kann beispielsweise die Vorspannung einer p-Kanal-Strombank (vgl. Fig. 2) eingestellt werden, die konstante und definierte Ströme liefert. Die Vorspannung uq', die mit der ungeregelten Versorgungsspannung ub gekoppelt ist, aktiviert im zweiten Verstärker eine Stromquelle, vgl. Fig. 3.

Es ist einsichtig, daß das Störverhalten durch den Anschluß der einzelnen Stufen an die geregelte Versorgungsspannung uc verbessert wird. Für den eingeschwungenen Betriebszustand ergeben sich hieraus keine Probleme. Anders sieht es jedoch aus, wenn der Spannungsregler aus dem spannungslosen Zustand startet. In dieser Startphase muß sichergestellt sein, daß die geregelte Versorgungsspannung uc, die anfänglich noch auf dem Bezugspotential M liegt, möglichst rasch ansteigt und in den normalen Arbeitsbereich gelangt. Im Anlaufbereich ist die richtige Regelrichtung keinesfalls gesichert. Die einzelnen Stufen der Regelschleife sind entweder noch völlig stromlos oder arbeiten hier noch nicht richtig. Noch schlimmer ist es, wenn die Regelrichtung im Anlaufbereich invertiert ist, weil dann der Spannungsregler überhaupt nie in seinen ordentlichen Betriebsbereich gelangen kann.

Diese Schwierigkeit überwindet gemäß der Erfindung eine Starteinrichtung st, die zwischen die erste und dritte Anschlußklemme k1, k3 geschaltet und so ausgebildet ist, daß beim Anlegen der ungeregelten Versorgungsspannung ub ein Querstrom über die Starteinrichtung fließen kann und eine Hilfsschaltung h aktiviert, die die Regelschleife zwangsweise in den regulären Betriebsbereich zieht. Starteinrichtungen sind beispielsweise auch bei Mikroprozessoren unter dem Begriff "Power-On-Reset-Schaltungen" bekannt, die beim Anlegen der Versorgungsspannung bestimmte Register oder logische Schaltstufen in einen definierten Zustand bringen. Die Realisierung von Starteinrichtungen kann sehr unterschiedlich sein - sie können entweder über interne Zeitglieder oder über Schaltschwellen gesteuert werden, mit denen Spannungen oder Ströme im Anlaufbereich überwacht werden.

Im Hinblick auf die unterschiedlichen Lastbedingungen ist für einen Spannungsregler die Überwachung von Spannungen oder Strömen gegenüber einer Zeitsteuerung vorzuziehen. Dies erfolgt nach Fig. 1 mittels eines ersten Fühlers f1, der im Referenznetzwerk einen Strom überwacht und die Starteinrichtung st aktiviert, solange dieser Strom noch niedrig ist und dadurch anzeigt, daß das Referenznetzwerk noch nicht im regulären Betriebsbereich ist.

Das Anlaufverhalten der Regelschleife kann weiter verbessert werden, wenn über einen zweiten Fühler f2 eine weitere Teilschaltung des Regelkreises überwacht wird. In Fig. 1 ist dies die Differenzeinrichtung d, die von einem Strom iq einer Stromquelle q1 gespeist wird, vgl. z.B. auch Fig. 2. Solange die Differenzeinrichtung noch nicht im regulären Betriebsbereich ist, wird mindestens ein Teil dieses Stromes iq oder ein mit ihm verkoppelter Strom i6 dem zweiten Fühler f2 zugeführt. Der zweite Fühler f2 aktiviert über diesen Strom i6 die Starteinrichtung st, solange die Differenzeinrichtung d den zugeführten Strom iq noch nicht selbst übernehmen kann.

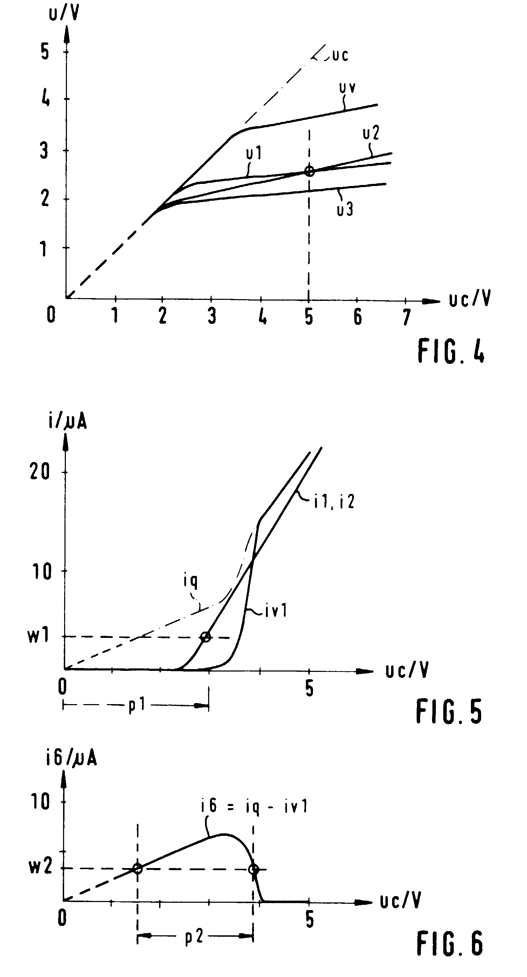

Durch den ersten und zweiten Fühler f1, f2 wird eine erste bzw. zweite Startphase p1 bzw. p2 definiert, die jeweils beendet wird, wenn eine erste bzw. zweite Schaltschwelle w1, w2 überschritten wird. Die erste und zweite Startphase p1, p2 überdecken den Anlaufbereich der geregelten Versorgungsspannung uc lückenlos, so daß auch im zeitlichen Ablauf eine lückenlose Überlappung sichergestellt ist, vgl. auch Fig. 5 und 6.

Während der Startphase aktiviert die Starteinrichtung st die Hilfsschaltung h, die ein erstes und zweites Hilfssignal x1, x2 erzeugt, um die Regelschleife in den regulären Betriebsbereich zu ziehen. Das erste Hilfssignal x1 zieht dabei den invertierenden Steuereingang des zweiten Verstärkers v2 in Richtung des Massepotentials M und bewirkt damit, daß das Ausgangspotential des Verstärkers ansteigt. Vorausgesetzt wird hierbei, daß sich der zweite Verstärker im aktiven Betriebsbereich befindet. Im Ausführungsbeispiel nach Fig. 3 ist dies nur gegeben, wenn eine Stromquelle t11 mittels des zweiten Hilfssignals x2 zugleich aktiviert wird. Gegebenenfalls erzeugt die Hilfsschaltung h weitere Hilfssignale oder Vorspannungen, die auch in anderen Stufen der Regelschleife Verwendung finden.

In Fig. 2 ist in einer ausführlicheren Darstellung ein besonders vorteilhaftes Ausführungsbeispiel für das Referenznetzwerk q, die Differenzstufe c, den ersten Verstärker v1, den ersten und zweiten Fühler f1 bzw. f2, die Starteinrichtung st und die Hilfsschaltung h dargestellt. Das Referenznetzwerk q ist dabei als eine vierfache Bandgap-Schaltung bg ausgeführt, die zugleich die erste und zweite Spannung u1, u2 zur Ermittlung der Regelabweichung liefert. Die Differenzstufe c und der erste Verstärker v1 stellen gemeinsam die Differenzeinrichtung d dar. Durch eine möglichst symmetrische Ausbildung der Bandgap-Schaltung bg in zwei sehr ähnliche Teilschaltungen, wird eine hohe Störsignalunterdrückung der Schaltung bewirkt.

Ein erster Teil der Bandgap-Schaltung bg enthält vier hintereinandergeschaltete Basis-Emitter-Strecken von pnp-Substrattransistoren pt, deren jeweilige Emitterfläche durch einen von der Auslegung vorgegebenen Wert e1 bestimmt wird. Ein zweiter Teil der Bandgap-Schaltung bg wird ebenfalls durch vier hintereinandergeschaltete Basis-Emitter-Strecken von vier weiteren pnp-Substrattransistoren pt gebildet, deren jeweilige Emitterfläche durch einen zweiten Wert e2 bestimmt wird. Im angenommenen Beispiel ist e2 zwölfmal so groß wie e1. Werden alle pnp-Substrattransistoren jeweils mit einem gleichen Emitterstrom (von z.B. 20 Mikroampere) gespeist, dann stellt sich am Emitter des jeweils höchstliegenden pnp-Substrat-Transistors eine bestimmte Spannung ein. Für den Bandgap-Teil mit der Emitterfläche e1 bzw. e2 ist dies der erste bzw. ein dritter Spannungspegel u1 bzw. u3, der an einem vierten bzw.

sechsten Knoten k4 bzw. k6 abgegriffen werden kann. Der jeweilige Spannungspegel ergibt sich aus den unterschiedlichen Emitterflächen e1, e2 und der Hintereinanderschaltung der vier pnp-Substrattransistoren pt nach folgender bekannter Beziehung:

$$u1 - u3 = 4 * k * T * 1/e * \ln(e2/e1),$$

mit: k = Boltzmannkonstante, T = absolute Temperatur und e = Elementarladung.

Im Ausführungsbeispiel von Fig. 2 ist der dritte Spannungspegel u3 bei Raumtemperatur etwa um 256 Millivolt niedriger als der erste Spannungspegel u1.

Die Funktionsweise der Bandgap-Schaltung besteht bekanntlich darin, daß der negative Temperaturkoeffizient der Basis-Emitter-Strecken durch den positiven Temperaturkoeffizient einer Spannung kompensiert wird, die proportional zur emitterflächenabhängigen Differenzspannung u1 - u3 ist. Genau betrachtet wird zu einer Spannung mit negativem Temperaturgang (Absolutwert) ein ganz bestimmter Spannungswert addiert, dessen Temperaturgang (Absolutwert) entgegengesetzt, aber im Betrag gleich groß ist. Dieser Spannungswert wird in der Regel dadurch gebildet, daß die emitterflächenabhängige Differenzspannung einem Spannungs-Stromumsetzer zugeführt ist, der in einem angeschlossenen Widerstand den durchfließenden Strom ändert. Die Spannungsdifferenz, die dabei am angeschlossenen Widerstand abfällt, hat dadurch den gleichen Temperaturkoeffizienten wie die emitterflächenabhängige Differenzspannung. Der Widerstandswert ist dabei so groß vorzugeben, daß der zur Kompensation erforderliche absolute Spannungswert genau getroffen wird. Im Ausführungsbeispiel nach Fig. 2 wird dies durch den Spannungsabfall am Widerstand r1 oder durch den Spannungssabfall an der Widerstands-Reihenschaltung r2, r3 erreicht. Die geregelte Versorgungsspannung uc ist damit die eigentliche, temperaturstabilisierte Bandgap-Spannung. Im angenommenen Beispiel mit i1 = i2 = 20 Mikroampere haben die Widerstände r1 und r2 jeweils einen Wert von 115 Kiloohm und der Widerstand r3 einen Wert von 12,8 Kiloohm.

Da im Sollzustand die beiden Bandgap-Ströme i1, k2 gleich groß sind, sind auch die Spannungen u1, u2 an den beiden Knoten k4, k5 gleich groß, so daß der Spannungsvergleich in der Regelschleife nur eine einfache Differenzmessung u1 - u2 erfordert. Die Kennlinriensteigung der beiden Spannungen u1, u2 als Funktion der Spannung uc sind unterschiedlich, die beiden Kennlinien schneiden sich jedoch bei einem Wert von ca. 2,7 Volt, wobei die Spannung uc einen Wert von ca. 5 Volt hat, vgl. auch Fig. 4. Mittels der Regelschleife wird die Ausgangsspannung uc der Bandgap-Schaltung bg solange nachgeregelt, bis die Spannungsdifferenz u1 - u2 zu null wird - die geregelte Versorgungsspannung uc hat dann den gewünschten Wert von etwa 5 Volt.

Die Differenzeinrichtung d ist in Fig. 2 durch einen Differenzverstärker c, v1 mit aktiver Last realisiert. Der Differenzeingang wird durch ein p-Kanal-Transistorpaar gebildet, dessen Gate-Elektroden an den vierten bzw. fünften Knoten k4, k5 angeschlossen sind und dessen gemeinsamer Source-Anschluß aus der p-Kanal-Stromquelle q1 mit dem Betriebsstrom iq gespeist ist. Den Ausgang des Differenzverstärkers bildet ein siebter Knoten k7, der zwischen dem Ausgang der aktiven Last und einem als Kaskode dienenden p-Kanal-Transistor liegt. Der siebte Knoten k7 liefert das Stellsignal s1, das dem invertierenden Eingang des zweiten Verstärkers v2 zugeführt wird. Der Gate-Anschluß der Stromquelle q1 liegt an der gleichen Vorspannung uq wie die p-Kanal-Transistoren, die die Bandgap-Schaltung bg speisen.

Die Starteinrichtung st in Fig. 2 besteht im wesentlichen aus einer Stromweiche, die von einem p-Kanal-Transistor t3 mit einem Strom i3 gespeist wird. Die Steuerung des jeweiligen Strompfades erfolgt durch ein p-Kanal-Transistorpaar t1, t2, das den Strom i3 in der ersten Startphase p1 zum größten Teil als Strom i4 einer ersten Last 11 und außerhalb der Startphase vollständig als Strom i5 einer zweiten Last 12 zuführt. Die erste Last 11 ist ein als Diode geschalteter n-Kanal-Transistor t4, und die zweite Last 12 ist die Serienschaltung aus zwei Diodenstrecken. Die erste Diodenstrecke ist durch einen n-Kanal-Transistor t5 gebildet und zweite Diodenstrecke durch einen pnp-Substrattransistor t6, dessen Basis- und Kollektoranschluß mit dem Bezugspotential M verbunden sind.

Der als Diode geschaltete n-Kanal-Transistor t4 bildet zugleich den Eingang der Hilfsschaltung h, die aus einer n-Kanal-Strombank gebildet ist und als Ausgangssignale ein erstes und zweites Hilfssignal x1, x2 liefert. Das erste Hilfssignal x1 zieht den siebten Knoten k7 und damit den invertierenden Eingang des zweiten Verstärkers v2 in Richtung auf das Bezugspotential M. Das zweite Hilfssignal x2 ist an einen Vorspannungseingang des Verstärkers v2 angeschlossen und zieht diesen ebenfalls in Richtung des Bezugspotentials M, vgl. Fig. 3. Dadurch werden alle erforderlichen Querstrompfade durchgeschaltet. Das erste Hilfssignal x1 ersetzt in der Anlaufphase das Ausgangssignal s1 des ersten Vertärkers v1.

Dem ersten Fühler f1 von Fig. 1 entspricht in Fig. 2 das Transistorpaar t1, t2, dessen Gate-Elektroden mit dem zweiten und vierten Knoten k2, k4 verbunden sind. In der frühen Anlaufphase liegen beide Gate-Anschlüsse nahezu auf dem Bezugspotential M, so daß die Stromverteilung lediglich vom Widerstandsverhältnis der ersten und zweiten Last 11, 12 abhängig ist. Da die einfache Diodenstrecke der ersten Last niederohmiger ist als die Serienschaltung der beiden Diodenstrecken in der zweiten Last, fließt der zugeführte Strom i3 vorwiegend über den Transistor t4 und aktiviert daher die Hilfsschaltung h. Beim Hochlaufen der geregelten Versorgungsspannung uc stellt sich erst dann eine Spannungsdifferenz zwischen dem zweiten und vierten Knoten k2, k4 ein, wenn ein Strom in der Bandgap-Schaltung fließen kann. Schließlich wird die Schaltschwelle w1 erreicht und Transistor t1 gesperrt. Dann fließt der gesamte Strom i3 über die zweite Last 12 ab. Damit ist die erste Startphase p1 beendet.

Dem zweiten Fühler f2 von Fig. 1, der einen anderen Betriebsstrom überwacht, entspricht in Fig. 2 die Schaltungsanordnung aus den beiden in Serie geschalteten p-Kanal-Transistoren t6 und t7. Transistor t6 liefert in der Stromquelle q1 den Betriebsstrom iq, der als Strom iv1 im Differenzverstärker c,v fließen sollte. In der Startphase befindet sich die Source-Drain-Strecke des Transistors t6 im ungesättigten Zustand, weil der Differenzverstärker den Betriebsstrom iq noch gar nicht übernehmen kann. Damit ist das Gate-Potential von Transistor t6 wesentlich niedriger als sein Drain-Potential uv am Knoten kv. Dieser Zustand wird von dem p-Kanal-Transistor t7 erkannt, dessen Gate- und Source-Elektrode mit der Gate bzw. Drain-Elektrode des sechsten Transistors t6 verbunden sind. Ferner ist die n-Wanne des siebten Transistors t7 ebenfalls mit der Drain-Elektrode des sechsten Transistors t6 verbunden.

Die Sättigungsgrenze des p-Kanal-Transistors t6 stellt die zweite Schaltschwelle w2, die der zweiten Fühlereinrichtung zugeordnet ist, dar, denn solange Transistor t6 nicht in Sättigung ist, fließt mindestens ein Teil des Betriebsstromes iq über den siebten Transistor t7 als Strom i6 in den Eingang der Hilfsschaltung h ab und aktiviert diese. Wenn Transistor t6 in Sättigung geht, dann wird Transistor t7 gesperrt und der gesamte Betriebsstrom iq fließt in den Differenzverstärker c,v1. Damit ist kein Aktivierungsstrom i6 für die Hilfsschaltung h vorhanden, wodurch diese inaktiv wird und die zweite Startphase p2 beendet.

Fig. 3 zeigt ein vorteilhaftes Ausführungsbeispiel für den zweiten Verstärker v2. Es ist ein Transkonduktanzverstärker mit einer A/B-Gegentaktausgangsstufe in CMOS-Technik. Eine nahezu identische Schaltung ist ausführlich in EP-A 0 460 263 beschrieben. In Fig. 3 verfügt der Verstärker v2 über zwei komplementäre Stromzweige, deren Steilheit mittels der Schaltungsauslegung gleich groß eingestellt wird. Durch die Ansteuerungsschaltung wird sichergestellt, daß die beiden Stromzweige mit gleich großen Spannungen angesteuert werden. Dies wird erreicht, indem sowohl der Gate-Anschluß des n-Kanal-Ausgangstransistors t9 als auch der Gate-Anschluß eines p-Kanal-Transistors t10 gemeinsam vom ersten Verstärker v1 angesteuert werden. Der Source-Anschluß des Transistors t10 liegt an einem Knoten k9 mit einem festem Potential u5 und der Source-Anschluß des Transistors t9 liegt auf dem Bezugspotential M. Mittels eines n-Kanal-Stromspiegels m1 wird der Ausgangsstrom des Transistors t10 gespiegelt und einem p-Kanal-Stromspiegel zugeführt, dessen Ausgangstransistor der Ausgangstransistor t8 der A/B-Gegentaktausgangsstufe ist. Die Drain-Elektroden des achten und neunten Transistors t8 und t9 sind miteinander verbunden und bilden den zweiten Schaltungsknoten k2. Damit die Steilheiten der beiden komplementären Stromzweige im Arbeitspunkt uc gleich sind, müssen auch die Transistoren t9, t10 die gleiche Steilheit aufweisen, wobei ein von 1 abweichendes Übersetzungsverhältnis der beiden Stromspiegel m1, m2 berücksichtigt werden muß.

Zwischen dem zweiten und siebten Knoten k2, k7 befindet sich ein Kondensator C von ca. 2 Pikofarad zur Regelkreisdämpfung, der ohne weiteres auf der Halbleiteroberfläche monolithisch integriert werden kann. Dies spart ein externes Bauelement und den zugehörigen Gehäuseanschluß ein.

In Fig. 3 ist der erste Verstärker v1 von einer Differenzspannung u4 gespeist, die beispielsweise der Differenzspannung zwischen dem vierten und fünften Knoten k4, k5 von Fig. 2 entspricht.

Die Vorspannungsquelle bq steuert mit ihrer Vorspannung uq' einen p-Kanal-Transistor t11, der über einen achten Knoten k8 als Stromquelle zwei hintereinandergeschaltete Diodenstrecken speist und dadurch eine Referenzspannung u5 für das feste Potential am Knoten k9 erzeugt. Da die Referenzspannung u5 nicht belastbar ist, wird ein zwischen den Knoten k8 und k9 fließender Ausgleichsstrom ia durch einen gleichgroßen Ausgangsstrom ia' einer Eins-zu-Eins-Mitkopplungsschaltung kompensiert, die mittels der beiden Stromspiegel m1, m2 realisiert ist. Die zugehörigen Strom-Übersetzungsverhältnisse sind in Fig. 3 als Zahlenwerte angegeben. Daraus ist auch ersichtlich, daß die Steilheit des Transistors t9 sechsmal größer sein muß als die Steilheit des Transistors t10.

Das Anlaufverhalten des in Fig. 3 dargestellten zweiten Verstärkers v2 ist ohne das zweite Hilfssignal x2 nicht sichergestellt. Der Gleichstrompfad für die Referenzspannung u5 wäre beispielsweise gesperrt.

Fig. 4 zeigt in einer schematisierten Darstellung einige Spannungsdiagramme des Ausführungsbeispiels nach Fig. 2. Die Spannungen u1, u2 und u3 der Bandgap-Schaltung bg haben dabei bis zu einem Ordinatenwert u von etwa 2,0 Volt nahezu den gleichen Wert wie die Abszissen-Spannung uc. Das heißt, daß bis zu diesem Wert keine Ströme i1, i2 über die Widerstände r1 bzw. r2, r3 fließen und die Bandgap-Schaltung inaktiv ist. Bei höheren Abszissenwerten uc stellt sich eine etwa konstante Differenzspannung zwischen dem Kennlinienverlauf u1 und u3 ein, die durch das Flächenverhältnis e1/e2 der Emitter nach der angegebenen Formel bestimmt ist.

Im Diagramm von Fig. 4 ist ferner der Spannungsverlauf u2 am Knoten k5 eingezeichnet. Im aktiven Bereich der Bandgap-Schaltung bg, wenn die Abszissenwerte der Spannungen u1, u2 über 2,5 Volt liegen, hat der Spannungsverlauf u1 eine geringere Steigung als der Spannungsverlauf u2. Beide Spannungen schneiden sich bei einem Ordinatenwert u von ca. 2,7 Volt, dem ein Abszissenwert uc von ca. 5 Volt zugeordnet ist - dies ist die eigentliche Bandgap-Ausgangsspannung, die der Sollwert der geregelten Versorgungsspannung uc ist.

Das Diagramm nach Fig. 4 enthält ferner den Spannungsverlauf uv am Knoten kv. Bis zu 3,5 Volt ist die Spannung uv identisch mit dem Abszissenwert uc, das heißt, daß in diesem Bereich der Spannung Transistor t6 im ungesättigtem Zustand ist und kein Strom iv1 in den Differenzverstärker c,v1 fließt. In Fig. 5 ist dies deutlicher erkennbar.

Fig. 5 zeigt schematisiert einige Stromdiagramme des Ausführungsbeispiels nach Fig. 2. Die Ströme i1, i2 der Bandgap-Schaltung haben bei kleinen Spannungen uc den Wert null und steigen erst oberhalb einer Spannung uc von etwa 2,3 Volt - dies entspricht der Reihenschaltung von vier Basis-Emitterstrecken - linear an. Der Differenzverstärker c,v1 befindet sich in diesem Spannungsbereich uc noch im stromlosen Zustand. Erst ab einer Spannung uc von etwa 3,5 Volt wird er aktiv, so daß er vom zugeführten Strom iq aus der Stromquelle q1 ein Teil als Strom iv1 übernehmen kann. Die Stromübernahme erfolgt dabei nicht abrupt, sondern in einem Übergangsbereich, der bei einem Abszissenwert uc von etwa 4 Volt beendet ist. Ab diesem Spannungswert wird der von der Stromquelle gelieferte Strom iq vollständig vom Differenzverstärker übernommen.

Die erste Schaltschwelle w1, die einen der Querströme i1, i2 der Bandgap-Schaltung bg überwacht und damit die erste Startphase p1 definiert, stellt keinesfalls sicher, daß sich der Differenzverstärker c, v1 im regulären Betriebsbereich befindet. Denn Fig. 5 zeigt, daß im ungünstigsten Fall die erste Schaltschwelle w1 bis zu einem Abszissenwert uc von 2,3 V absinken kann, bei dem der Differenzverstärker überhaupt noch keinen Strom aufnimmt.

Im schematisierten Diagramm von Fig. 6 ist der Differenzstrom i6 des Ausführungsbeispiels von Fig. 2 als Funktion der Spannung uc dargestellt, wobei i6 = iq - iv1 ist. Der Differenzstrom i6 ist der Starteinrichtung st zugeführt und definiert über die zweite Schaltschwelle w2 die zweite Startphase p2, die etwa bei einem Abszissenwert uc von etwa 3,8 Volt beendet wird. Da die zweite Schaltschwelle w2 auch bei einer niederen Spannung uc durch den Differenzstrom i6 unterschritten wird, ist eine Kombination und damit Überlappung der ersten und zweiten Startphase p1, p2 erforderlich. Dies erfolgt in der Starteinrichtung st von Fig. 2 durch die Addition der Ströme i4 und i6 im Eingang der Hilfsschaltung h.

**Patentansprüche**

1. Spannungsregler mit einer Regelschleife, die ein Referenznetzwerk (q) und eine Differenzeinrichtung (d) enthält, deren Stromversorgung an eine zweite Anschlußklemme (k2), die den Ausgang des Spannungsreglers bildet, angeschlossen ist, wobei eine Starteinrichtung (st) während einer Startphase (p1, p2) die Regelschleife mittels einer Hilfsschaltung (h) in einen regulären Betriebsbereich zieht,

gekennzeichnet durch folgende Merkmale:

- die Starteinrichtung (st) ist mit einem ersten Fühler (f1) zur Erkennung eines nicht regulären Betriebsbereiches des Referenznetzwerkes (q) verbunden,

- die Kriterien für den nichtregulären Betriebsbereich liefern Strom- und/oder Spannungswerte, und

- der erste Fühler (f1) aktiviert die Starteinrichtung (st) in Abhängigkeit von einer ersten Schaltschwelle (w1), die eine erste Startphase (p1) definiert.

2. Spannungsregler nach Anspruch 1, gekennzeichnet durch folgende Merkmale:

- die Starteinrichtung (st) ist mit einem zweiten Fühler (f2) zur Erkennung eines nichtregulären Betriebsbereichs der Differenzeinrichtung (d) verbunden,

- die Kriterien für den nichtregulären Betriebsbereich liefern Strom- und/oder Spannungswerte, und

- der zweite Fühler (f2) aktiviert die Starteinrichtung (st) in Abhängigkeit von einer zweiten Schaltschwelle (w2), die eine zweite Startphase (p2) definiert.

3. Spannungsregler nach Anspruch 2, dadurch gekennzeichnet, daß die erste und zweite Schaltschwelle (w1, w2) derart vorgegeben sind, daß die erste und zweite Startphase (p1, p2) den nichtregulären Betriebsbereich der Regelschleife lückenlos abdecken.

4. Spannungsregler nach Anspruch 2 oder 3, gekennzeichnet durch folgende Merkmale:

- der zweite Fühler (f2) führt während der zweiten Startphase (p2) den für die Differenzeinrichtung (d) bestimmten Betriebsstrom (iq) ganz oder teilweise als ein Aktivierungsstrom (i6) der Starteinrichtung (st) zu, und

- die Stromübernahme des Betriebsstromes (iq) ist von der Sättigungsspannung einer für die Differenzeinrichtung (d) zuständigen Stromquelle (q1) abhängig.

5. Spannungsregler nach mindestens einem der Ansprüche 1 bis 4, dadurch gekennzeichnet, daß das Referenznetzwerk (q) eine Bandgap-Schaltung (bg) enthält.

6. Spannungsregler nach mindestens einem der Ansprüche 1 bis 5, dadurch gekennzeichnet, daß die Regelschleife ein Stellglied (r) enthält, das ein Transkonduktanzverstärker ist.

7. Spannungsregler nach einem der Ansprüche 1 bis 6, dadurch gekennzeichnet, daß der Spannungsregler in CMOS-Technik monolithisch integriert ist.

8. Spannungsregler nach Anspruch 7, dadurch gekennzeichnet, daß der Spannungsregler in CMOS-Technik auch Substrattransistoren enthält, die auf der Halbleiteroberfläche monolithisch integriert sind.

9. Spannungsregler nach einem der Ansprüche 1 bis 8, dadurch gekennzeichnet, daß gemeinsam mit dem Spannungsregler auf der Halbleiteroberfläche Signalverarbeitungseinrichtungen (sp) monolithisch integriert sind, insbesondere in Standard-CMOS-Technik, wobei die Auslegung dieser Signalverarbeitungseinrichtungen (sp) und ihr Herstellungsprozeß im wesentlichen für den Wert der Ausgangsspannung des Spannungsreglers, der geregelten Versorgungsspannung (uc), optimiert sind.

**Revendications**

1. Régulateur de tension comportant une la boucle de régulation qui comprend un système de réseau de référence (q) et un circuit différentiel (d) dont l'alimentation en courant est reliée à une deuxième borne de raccordement (k2) qui constitue la sortie du régulateur de tension, dans lequel un dispositif de démarrage (st) entraîne la boucle de régulation dans une zone de fonctionnement régulier au moyen d'un circuit auxiliaire (h) pendant une phase de démarrage (p1, p2)
caractérisé par les caractéristiques suivantes :

- le dispositif de démarrage (st) est relié à un premier capteur (f1) pour la reconnaissance d'une zone de fonctionnement non régulier du système de réseau de référence (q),

- les critères pour la zone de fonctionnement non régulier fournissent des valeurs de courant et/ou de tension, et

- le premier capteur (f1) active le dispositif de démarrage (st) en fonction d'un premier seuil de commutation (w1) qui définit une première phase de démarrage (p1).

2. Régulateur de tension selon la revendication 1, caractérisé par les caractéristiques suivantes :
le dispositif de démarrage (st) est relié à un deuxième capteur (f2) pour la reconnaissance d'une zone de fonctionnement non régulier du circuit différentiel (d)

- les critères pour la zone de fonctionnement non régulier fournissent des valeurs de courant et/ou de tension, et
- le deuxième capteur (f2) active le dispositif de démarrage (st) en fonction d'un deuxième seuil de commutation (w2) qui définit une deuxième phase de démarrage (p2).

3. Régulateur de tension selon la revendication 2, caractérisé en ce que les premier et deuxième seuils de commutation (w1, w2) sont prédéterminés de telle manière que les première et deuxième phases de démarrage (p1, p2) recouvrent sans faille la zone de fonctionnement non régulier de la boucle de régulation.

4. Régulateur de tension selon la revendication 2 ou 3, caractérisé par les caractéristiques suivantes :

- le deuxième capteur (f2) envoie, en tant que courant d'activation (i6), en totalité ou en partie, pendant la deuxième phase de démarrage (p2), le courant de service (iq) déterminé pour le circuit différentiel (d) au dispositif de démarrage (st), et
- la réception du courant de service (iq) dépend de la tension de saturation d'une source de courant (q1) convenant pour le circuit différentiel (d).

5. Régulateur de tension selon au moins l'une des revendications 1 à 4, caractérisé en ce que le système de réseau de référence (q) contient un circuit à barrière de potentiel (bg).

6. Régulateur de tension selon au moins l'une des revendications 1 à 5, caractérisé en ce que la boucle de régulation contient un composant de réglage (r) qui est un amplificateur à conductance mutuelle.

7. Régulateur de tension selon au moins l'une des revendications 1 à 6, caractérisé en ce que le régulateur de tension est intégré de manière monolithique selon la technique CMOS.

8. Régulateur de tension selon la revendication 7, caractérisé en ce que le régulateur de tension en technique CMOS contient aussi des transistors de substrat qui sont intégrés de manière monolithique sur la surface de semiconducteur.

9. Régulateur de tension selon au moins l'une des revendications 1 à 8, caractérisé en ce que, sur la surface de semi-conducteur, sont intégrés de manière monolithique en commun avec le régulateur de tension des dispositifs de traitement de signal (sp), en particulier dans la technique normale CMOS, la conception de ces dispositifs de traitement de signal (sp) et leur procédé de fabrication étant optimisés pour la valeur de la tension de sortie du régulateur de tension, la tension d'alimentation régulée (uc).

## Claims

1. A voltage regulator with a control loop comprising a reference network (q) and a difference device (d) whose power supply is connected to a second terminal (k2) forming the output of the voltage regulator, and with a starting device (st) which during a starting phase (p1, p2) pulls the control loop into a regular operating range by means of an auxiliary circuit (h), <u>characterized by the following features:</u>

- The starting device (st) is connected to a first sensor (f1) for recognizing a regular operating range of the reference network (q);

- the criteria for the nonregular operating range are provided by current and/or voltage values; and

- the first sensor (f1) activates the starting device (st) at a first switching threshold (w1) which defines a first switching phase (p1).

2. A voltage regulator as claimed in claim 1, characterized by the following features:

- The starting device (st) is connected to a second sensor (f2) for recognizing a nonregular operating range of the difference device (d):

- the criteria for the nonregular operating range are provided by current and/or voltage values; and

- the second sensor (f2) activates the starting device (st) at a second switching threshold (w2) which defines a second starting phase.

3. A voltage regulator as claimed in claim 2, characterized in that the first and second switching thresholds (w1, w2) are so preset that the first and second starting phases (p1, p2) completely cover the nonregular operating range of the control loop.

4. A voltage regulator as claimed in claim 2 or 3, characterized by the following features:

- During the second starting phase (p2), the second sensor (f2) feeds the operating current (iq) intended for the difference device (d), wholly or in part, as an activation current (i6) to the starting device (st); and

- the transfer of the operating current (iq) into the difference device (d) is dependent on the saturation voltage of a current source (q1) for the difference device (q).

5. A voltage regulator as claimed in at least one of claims 1 to 4, characterized in that the reference network (q) comprises a bandgap circuit (bg).

6. A voltage regulator as claimed in at least one of claims 1 to 5, characterized in that the control loop is a transconductance amplifier.

7. A voltage regulator as claimed in any one of claims 1 to 6, characterized in that the voltage regulator is implemented in CMOS monolithic integrated circuit technology.

8. A voltage regulator as claimed in claim 7, characterized in that the voltage regulator in CMOS technology includes substrate transistors which are integrated on the same semiconductor surface.

9. A voltage regulator as claimed in any one of claims 1 to 8, characterized in that together with the voltage regulator, signal processing devices (sp) are integrated on the same semiconductor surface, particularly in standard CMOS technology, the design of said signal processing devices (sp) and their fabrication process being optimized essentially for the value of the output voltage of the voltage regulator, the regulated supply voltage (uc).

FIG. 1

FIG. 2

FIG. 3

FIG. 4

FIG. 5

FIG. 6